# EUROPEAN PATENT SPECIFICATION

(11) **EP 2 860 534 B1**
(45) Date of publication and mention of the grant of the patent: **31.08.2016**
(21) Application number: 14187895.9
(22) Date of filing: 07.10.2014
(51) Int. Cl.: G01R 13/02, G06T 11/20

(54) **Stochastic rasterization of waveform trace displays**
Stochastische Rasterung zur Anzeige von Wellenformen
Rastérisation stochastique d'affichages de trace de forme d'onde

(30) Priority: 07.10.2013 US 201361887554 P; 27.05.2014 US 201414288140
(43) Date of publication of application: 15.04.2015
(73) Proprietor: Tektronix, Inc., Beaverton, Oregon 97077-0001 (US)
(72) Inventor: Hubbard, John, Beaverton, OR 97077-0001 (US); Overton, Michael, Beaverton, OR 97077-0001 (US)
(74) Representative: Clarke, Jeffrey David

(56) References cited:
- EP-A2- 0 947 840
- EP-A2- 0 962 779
- US-A1- 2003 152 266
- US-A1- 2009 309 879
- LASZLO HARS: "Random Number Generators in Secure Disk Drives", EURASIP JOURNAL ON EMBEDDED SYSTEMS, vol. 26, no. 9, 1 January 2009 (2009-01-01), page 1, XP055174105, ISSN: 1687-3963, DOI: 10.1007/BF00193563

## Description

### FIELD OF THE INVENTION

This disclosure is directed to waveform instruments, and more particularly, to a method of stochastically incrementing stored values in a waveform instrument.

### BACKGROUND

Waveform monitors generate images of waveforms so that a technician may visualize electric circuit activity. They are commonly used to measure video signals, but may measure other types of signals as well.

Present waveform monitors use external memory to store data to generate waveform traces. Data that forms the waveforms on a pixelated display is incremented in the external memory each time a memory location associated with the pixel is accessed. After an incrementing time period finishes, the stored values are mapped to the display. Stored values that have a high value are displayed as brighter pixels than ones that have a low value. Presenting all of the high and low values on the display as pixels having different brightnesses generates the waveform for the operator.

The external memory of present waveform monitors is very large. For a typical 1024x700 display in which each memory location stores up to an 18 bit value, the size of the memory is 12,902,400 bits. If bit depth is reduced in an effort to save the cost of such a large memory, dynamic range of the pixel brightness is lost, which lessens the performance and amount of information that can be presented to the user.

Embodiments of the invention address these and other issues in the prior art.
US2009/0309879 relates to a waveform processor system that may update pixel state information as a function of current pixel state information by comparing a randomized value to a set of predetermined threshold values that correspond to different permitted pixel states.

### SUMMARY OF THE DISCLOSURE

There is provided, in a waveform monitor, a method of stochastically incrementing a stored value in a memory store as set out in claim 1, and a stochastic incrementer for generating an incrementing signal in a waveform monitor as set out in claim 4. Embodiments of the invention include methods of incrementing a stored value in a memory store of a waveform monitor. Such methods include first dividing memory values that are between a minimum and maximum value into two or more value ranges. Next an increment percentage is ascribed for each of the value ranges. During operation, first a present stored value is read from the memory store and its ascribed increment percentage for the particular range is selected. Then the present stored value is incremented based on the percentage for the particular range.

These methods may be performed by a stochastic incrementer for generating an incrementing signal in a waveform monitor having a display generated from pixel values. Such an incrementer includes an input structured to receive a signal indicating that a waveform being tested matches a current pixel value. It also includes a stochastic generator coupled to the input and structured to generate the incrementing signal according to a stochastic probability. In some embodiments the stochastic incrementer may be implemented by a number generator, a mask, and a controller.

### BRIEF DESCRIPTION OF THE DRAWINGS

Fig. 1 is a functional block diagram of a conventional waveform monitor.
Fig. 2 is a functional block diagram of a waveform monitor according to embodiments of the invention.
Figs. 3A, 3B, and 3C are graphs of example functions that may be programmed into a stochastic incrementer according to embodiments of the invention.
Fig. 4 is an example flow diagram illustrating setup operations used in embodiments of the invention.
Fig. 5 is an example flow diagram illustrating run-time operations used in embodiments of the invention.
Fig. 6 is a functional block diagram that illustrates an example implementation of a stochastic incrementer according to embodiments of the invention.

### DETAILED DESCRIPTION

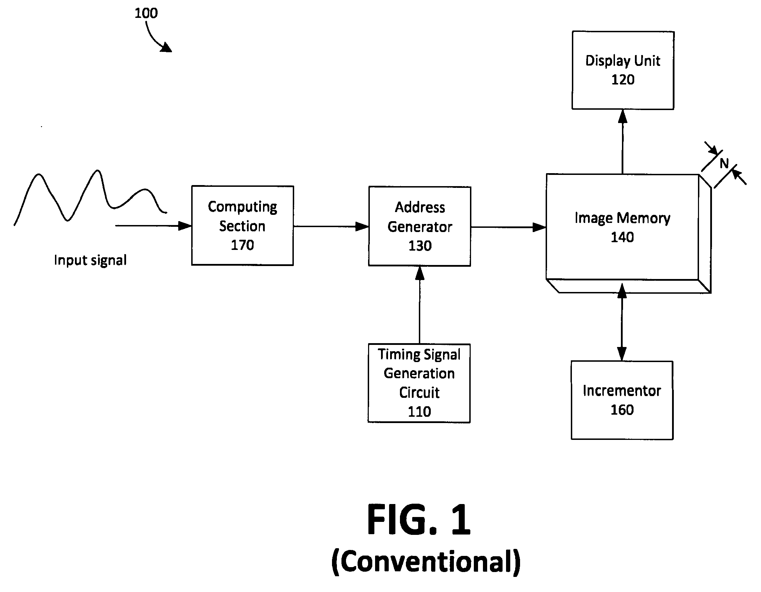

Fig. 1 is a functional block diagram of a conventional waveform monitor 100. The input signal is processed by a computing section 170 to create various display modes. The output of the computing section 170 and a timing signal generating circuit 110 are inputs to an address generator 130. The address generator 130 generates an address signal for the pixels of an image memory 140. In operation, a waveform signal is received at an input and data generated from the waveform signal and the timebase is stored in an image memory 140 for each address generated by the address generator 130. Data may be accumulated for several input cycles before the contents of the memory 140 is transferred for display on the display unit 120, for example during a vertical synchronization period. The memory 140 is then reset and an accumulation cycle begins again. Some waveform monitors may include two memories so that one memory is being accumulated while the second memory is being formatted for display. The method by which data is stored in memory 140 is that, for each instance when a given address is accessed, the current memory value is read, then incremented by incrementor 160, then written back to the memory. This increases the brightness value for the selected pixel in proportion to the number of times its address has been accessed.

Conventional waveform monitors required large memories for their image memory 140. Memory is often measured in bit depth, illustrated in Fig. 1 as N, and a larger bit depth gives increased dynamic range for capturing the input signal. Conventional waveform monitors such as the monitor 100 of Fig. 1 typically have large bit-depths of memory storage, on the order of 15-18 bits, which gives broad dynamic range to be mapped into the brightness value of pixels in the display. In many conventional systems, after the data is read from the memory it is then compressed down to 6-8 bits to drive the display.

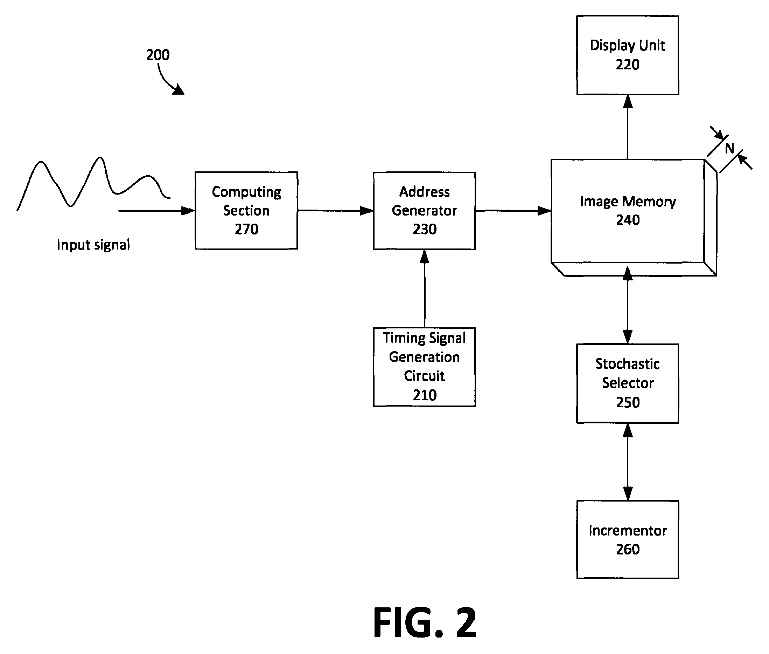

A waveform monitor 200 according to embodiments of the invention is illustrated in Fig. 2. Many of the components from the waveform monitor 100 are repeated in Fig. 2, and discussion of similar components is omitted for brevity.

Embodiments of the invention include a stochastic selector 250 between the image memory 240 and the incrementer 260. The stochastic selector 250 determines when the incrementor 260 is controlled to increase the brightness of the selected pixel.

Whereas conventional waveform monitors required large memories for their image memory 240 for large dynamic range, embodiments of the invention preserve the dynamic range while using reduced bit depths. These embodiments use a stochastic selector 250 that may be programmed with a function that affects operation of the waveform monitor 200, as described in detail below.

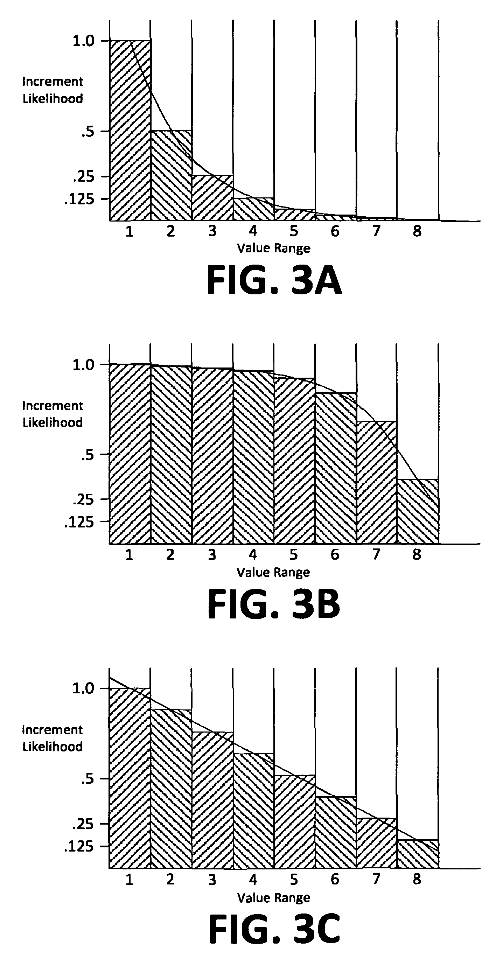

Fig. 3A is a graph illustrating a function that may be used by the stochastic selector 250 to determine when memory values are to be incremented by the incrementer 260 in the memory 240 of Fig. 1. Initially, the number of potential memory values are divided into separate value ranges. Fig. 3A illustrates that the memory values are divided into eight ranges. For example, if the pixel memory depth N of memory 240 (Fig 2) is 6 bits, then for each pixel the memory 240 may store sixty-four separate values between 0 and 63. The sixty-four values may be divided into eight ranges each having 8 values, for example.

Each value range is associated with an increment percentage or increment likelihood. In the example of Fig. 3A, the first value range has an increment likelihood of 1.0, while the second value range has an increment likelihood of 0.5. The third value range has an increment likelihood of 0.25. In this example, each value range has an increment likelihood of one-half its neighboring range value, until the eighth value range of 0.0078125 is reached. These value ranges and numeric ratios that correspond to the function of Fig. 3A are illustrated in Table 1.

**TABLE 1**

| **Range #** | **6-bit Value Range** | **Increment ratio** | **Increment likelihood** | **Increment percentage** |
|---|---|---|---|---|
| 1 | 0-7 | 1:1 | 1.0 | 100% |
| 2 | 8-15 | 1:2 | .5 | 50% |
| 3 | 16-23 | 1:4 | .25 | 25% |
| 4 | 24-31 | 1:8 | .125 | 12.5% |
| 5 | 32-39 | 1:16 | .0625 | 6.25% |
| 6 | 40-47 | 1:32 | .03125 | 3.125% |
| 7 | 48-55 | 1:64 | .015625 | 1.5625% |
| 8 | 56-63 | 1:128 | .0078125 | 0.78125% |

In operation, instead of incrementing the image memory location of the memory 240 (Fig. 2) every time the specific pixel for the memory location matches the incoming waveform, as in conventional waveform monitors, the corresponding memory location instead is incremented according to the increment likelihood of the present particular value range. For example, using the ranges described in Table 1 for a 6-bit memory depth, the first eight times the memory location is attempted to be updated by virtue of measuring the waveform, the memory location is updated every time, because the increment percentage is 100% for value range 1. If the current memory value was thirty-five, however, then the current value range would be 5, and the memory would only be incremented approximately once for every 16 times that the waveform matched the pixel related to that memory location. If the current memory value was sixty, placing it in value range 8, the memory would only be incremented 0.78% (1:128) of the time.

In practice, this stochastic process makes it more difficult to update the higher memory values because the likelihood that the memory values increase is being discounted the higher the present memory value is. This is a stochastic incrementing compression system. When the memory values are read from the memory 240 for display, the values represent a compressed version of the high-dynamic range that was present in the original signal.

As seen in Figs 3B and 3C, any function may be mapped into the value ranges of the memory locations. Whereas Fig. 3A illustrates a function that quickly decays, i.e., it gets harder to update the higher memory values, the function of Fig. 3B stays relatively flat until the higher values are reached. The function of Fig. 3C illustrates a constantly decreasing function. In other embodiments the function (not illustrated) may even be an increasing function, making the beginning values harder to increment while the later values increment easier to increment.

Other embodiments of the invention may use more or fewer than eight value ranges, and other embodiments may have bit depths of any value.

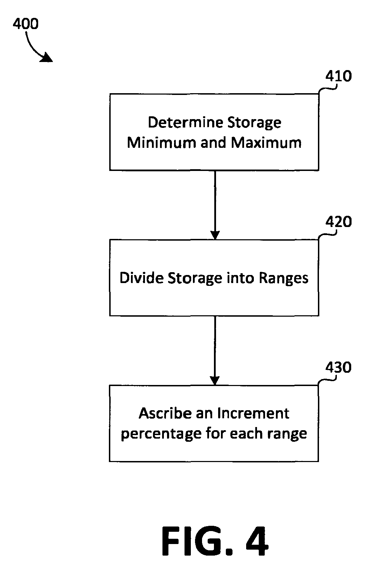

Fig. 4 is an example flow diagram illustrating setup operations used in embodiments of the invention. A flow 400 starts at an operation 410 where a minimum and maximum storage values are determined. For example, in a 7-bit depth memory system, the minimum values is 0 while the maximum value is 127. Next, values that are between the minimum and maximum values are divided into value ranges in an operation 420. The value ranges may be equal ranges but need not be equal. An operation 430 associates or ascribes an increment percentage for each of the value ranges. Increment percentages may be selected based on a particular function. Operations 410 - 430 need only be performed once, or each time a new function is to be programmed into the stochastic incrementer.

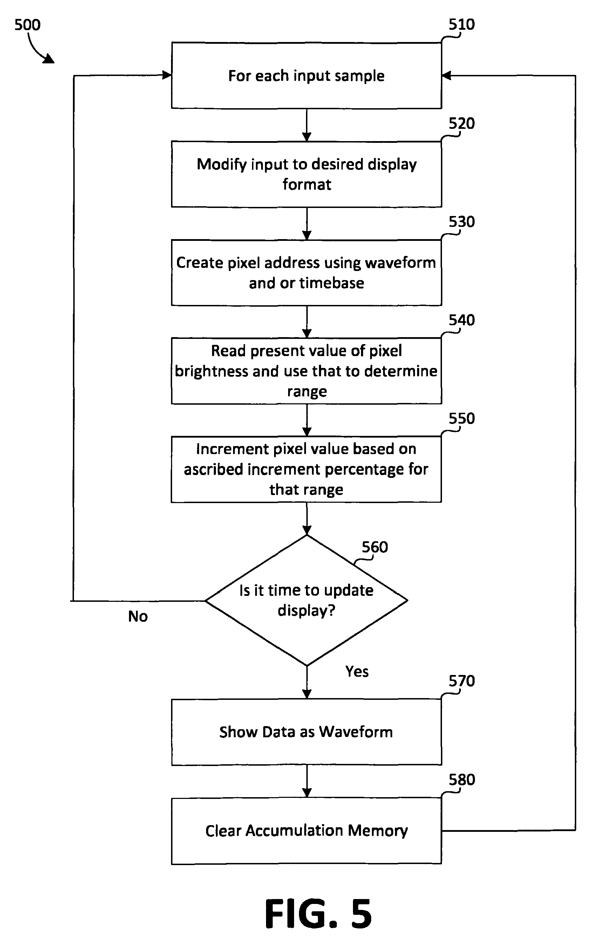

Fig. 5 is an example of a flow diagram illustrating run-time operations used in embodiments of the invention. Operations 510-580 occur many times as the waveform monitor is reading waveforms and generating output. Initially, a waveform input is read and it is determined which memory location is associated with the input sample. For example, an operation 510 receives a sample and the input is modified by operation 520 to a desired display format. An operation 530 generates a pixel address using input from the waveform and/or a timebase.

Next, an operation 540 reads the present value of the pixel value from the memory and determines the present value range of the pixel value.

An operation 550 increments the value based on the increment percentage for the present value range. For example, if the increment percentage is .25, then the memory value will be incremented, on average, only one of four times that the waveform matched the associated pixel value of the memory value. There are many ways of implementing such a stochastic system, as described in more detail below.

Once the operation 560 determines that the present data gathering period is over, for example at the next vertical synchronization period, then the accumulated data may be retrieved from the memory and shown on the display as the generated waveform in an operation 570.Because the data is already compressed, it typically requires little or no processing to drive the display. After the data is displayed in operation 570, the memory values are reset to zero in an operation 580, and the flow 500 repeats.

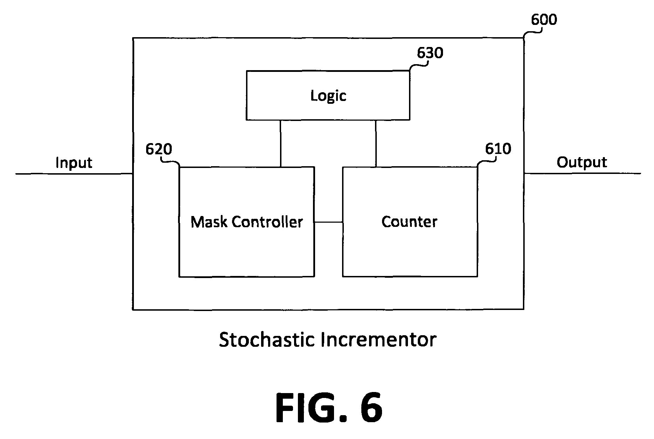

Fig. 6 illustrates an example implementation of a stochastic incrementer 600. The stochastic incrementer 600 incorporates the stochastic selector block 250 having an output coupled to the incrementer block 260 of Fig. 2. The stochastic incrementer 600 includes an input that receives an input every time the waveform being tested (Fig. 2) matches the current pixel value being evaluated. In conventional systems, an associated memory location would be incremented each time such an input is received. Instead, the stochastic incrementer 600 uses a counter 610 and mask controller 620 controlled by logic 630 to increment the memory location using stochastic methods.

The counter 610 is a standard counter having a number of bits, for example 10. The counter automatically loops after it exceeds its capacity. The mask controller 620 generates a mask that masks certain of the bits from consideration depending on the particular value range determined above.

For example, assume there are four value ranges, 1-4, of equal size, that have associated increment likelihood of 1, 0.5, 0.25, and 0.125, respectively. Next assume that the memory location associated with the current pixel has just been reset and currently has a value set to zero. Finally, assume that the memory location where values are being stored has 4-bit depth, giving possible values of 0-16. Therefore values 0-3 are in the first value range, values 4-7 are in the second value range, values 8-11 are in the third value range, and values 12-15 are in the fourth value range.

In operation in this example, the first four times the input to the stochastic incrementer 600 is received, an output is generated, which increments the memory value to 4. No mask is necessary and the counter 610 need not be used for value range 1, because the increment likelihood is 1. That is, for the first four times the stochastic incrementer 600 receives an input, an output is likewise generated.

After the stored value exceeds 3, the current value range is the second range, which has an increment likelihood of 0.5. To implement the stochastic incrementing operation, the stochastic incrementer 600 uses the mask controller 620 to mask all but one of the bits of the counter 610. Then the one unmasked bit is considered. If the stochastic incrementer 600 receives an input when the unmasked bit is 0, then no incrementing output is generated by the stochastic incrementer. If instead the unmasked bit is 1, then the stochastic incrementer 600 generates an incrementing output, and the memory value is increased. Using a mask that masks all but a single bit implements the increment likelihood of 0.5, as the stochastic incrementer 600 is likely to generate an incrementing output only one time out of every two inputs received while value range 2 is active.

Value range 3, having a likelihood of 0.25 may be implemented by the mask controller 620 masking all but two bits of the counter 610. When value range 3 is active, the stochastic incrementer 600 generates an incrementing output, on average, only once for every four inputs. For example, the output may be generated only when the unmasked bits of the counter are 11, and not when the unmasked bits are 00, 01, or 10.

Finally, value range 4 may be implemented by the mask controller 620 masking all but three bits, and generating the incrementing output only when the three unmasked bits are 111, and not when they are any other combination.

As can be appreciated, the counter 610 need not be a counter at all, but may be implemented by a random number generator. Also, the masked or unmasked bits need not be contiguous. Also any combination of states may be used to implement the desired probability.

Further, the counter 610 may be of any size, so long as it is large enough to generate enough unmasked values for the mask controller 620 to accommodate any incrementing likelihood for the number of value ranges.

The logic 630 may be used to determine which value range is the current range, and to control the mask controller 620.

Using a stochastic incrementer 600 that includes a counter and mask controller is but only one way to implement a stochastic system that accords to embodiments of the invention. For example the stochastic system could be implemented by look up table.

The stochastic incrementer 400 may be embodied in firmware, specifically designed circuitry such as an ASIC or FPGA, or may be implemented by one or more software process running on a processor. In other embodiments the stochastic incrementer 400 may include a combination of firmware, ASIC, FPGA, and software.

Using methods of rasterization such as the 6 bit system described in table 1 above, the resulting rasterization saturates at approximately 2040 writes per location. To achieve this dynamic range without this invention would require 11 bits of memory. Therefore waveform monitors incorporating this invention, using stochastic incrementing techniques, have approximately the same dynamic range, 2040 individual writes, while using only six-bit memory depth rather than requiring the 11 bit memory. By simply changing the percentages in each range, the same 6 bit stochastic system can emulate other linear bit depths such as 8, 15 or 18 bits.

Although specific embodiments of the invention have been illustrated and described for purposes if illustration, it will be understood that various modifications may be made without departing from the scope of the invention. Accordingly, the invention should not be limited except as by the appended claims.

## Claims

1. A method of stochastically incrementing a stored value in a memory store, of a waveform monitor, that has a minimum and maximum value, the method comprising:
dividing values that are between the minimum and maximum values into two or more value ranges (420);
ascribing an increment percentage for each of the value ranges (430);
reading a present stored value from the memory store;
selecting the ascribed increment percentage of the value range associated with the present stored value as a present increment percentage (540); and
incrementing the present stored value based on the present increment percentage (550);
wherein the method is **characterised in that** incrementing the present stored value based on the present increment percentage comprises:
checking a current state of at least some bits of a counter (610); and
determining that one or more possible counter values within an unmasked region of the counter (610) will cause the stored value to increment.

2. The method according to claim 1, in which the stored value is a stored intensity value.

3. The method according to claim 1, in which checking a current state of at least some bits of a counter comprises adjusting a number of bits in a masked region of the counter.

4. A stochastic incrementer (600) for generating an incrementing signal in a waveform monitor having a display generated from pixel values, the incrementer comprising:
an input structured to receive a signal indicating that a waveform being tested matches a current pixel value; and
a stochastic generator coupled to the input and structured to generate the incrementing signal according to a stochastic function;
**characterised in that** the stochastic generator comprises:
a counter (610) having a number of individual bits in which each bit is individually operable; and
a programmable mask structured to mask one or more bits of the counter.

5. The stochastic incrementer (600) of claim 4 in which the stochastic generator further comprises a comparator structured to generate the incrementing signal output based on a state of the input and a state of the unmasked bits of the counter.

6. The stochastic incrementer (600) of claim 4 in which the programmable mask (620) is associated with one of a number of increment value ranges.

7. The stochastic incrementer (600) of claim 6 in which the value ranges are determined at least partially based on a minimum pixel value and a maximum pixel value.

## Patentansprüche

1. Verfahren zum stochastischen Inkrementieren eines in einem Speicher eines Waveformmonitors gespeicherten Wertes, der einen Mindest- und Höchstwert aufweist, wobei das Verfahren folgendes umfasst:
Aufteilen der Werte, die zwischen den Mindest- und Höchstwerten liegen, in zwei oder mehr Wertebereiche (420);
Zuschreiben eines Inkrementprozentwertes zu jedem der Wertebereiche (430);
Auslesen eines gegenwärtig gespeicherten Wertes aus dem Speicher;
Auswählen des zugeschriebenen Inkrementprozentwertes, der dem gegenwärtig gespeicherten Wert entspricht, als gegenwärtigen Inkrementprozentwert (540); und
Inkrementieren des gegenwärtig gespeicherten wertes auf der Basis des gegenwärtigen Inkremenprozentwertes (550);
wobei das Verfahren **dadurch gekennzeichnet ist, dass** das Inkrementieren des gegenwärtig gespeicherten Wertes auf der Basis des gegenwärtigen Inkrementprozentwertes folgendes umfasst:
Prüfen eines aktuellen Zustands wenigstens einiger Bits eines Zählers (610); und
Bestimmen, dass ein oder mehrere mögliche Zählerwerte in einem nicht maskierten Bereich des Zählers (610) eine Inkrementierung des gespeicherten Wertes bewirken.

2. Verfahren nach Anspruch 1, wobei der gespeicherte Wert ein gespeicherter Intensitätswert ist.

3. Verfahren nach Anspruch 1, wobei das Prüfen eines aktuellen Zustands wenigstens einiger Bits eines Zählers das Anpassen einer Anzahl von Bits in einem maskierten Bereich des Zählers umfasst.

4. Stochastischer Inkrementierer (600) zum Erzeugen eines Inkrementierungssignals in einem Waveformmonitor mit einer aus Pixelwerten erzeugten Anzeige, wobei der Inkrementierer folgendes umfasst:
einen Eingang, der so gestaltet ist, dass er ein Signal empfängt, das anzeigt, dass eine geprüfte Wellenform einem aktuellen Pixelwert entspricht; und
einen stochastischen Generator, der mit dem Eingang gekoppelt und so gestaltet ist, dass er das Inkrementierungssignal gemäß einer stochastischen Funktion erzeugt;
**dadurch gekennzeichnet, dass** der stochastische Generator folgendes umfasst:
einen Zähler (610) mit einer Reihe einzelner Bits, wobei jedes Bit einzeln funktionsfähig ist; und
eine programmierbare Maske, die so gestaltet ist, dass sie ein oder mehrere Bits des Zählers maskiert.

5. Stochastischer Inkrementierer (600) nach Anspruch 4, wobei der stochastische Generator ferner einen Komparator umfasst, der so gestaltet ist, dass er die inkrementierende Signalausgabe auf der Basis eines Zustands des Eingangs und eines Zustands der nicht maskierten Bits des Zählers erzeugt.

6. Stochastischer Inkrementierer (600) nach Anspruch 4, wobei die programmierbare Maske (620) einem einer Reihe von Inkrementierungswertebereichen zugeordnet ist.

7. Stochastischer Inkrementierer (600) nach Anspruch 6, wobei die Wertebereiche wenigstens teilweise auf der Basis eines Mindestpixelwerts und eines Höchstpixelwerts bestimmt werden.

## Revendications

1. Procédé permettant d'incrémenter de manière stochastique une valeur stockée dans une banque de mémoire, d'un moniteur de forme d'onde, qui a des valeurs minimale et maximale, le procédé comprenant les étapes consistant à :
diviser les valeurs comprises entre les valeurs minimale et maximale en deux plages de valeurs (420) ou plus ;
attribuer un pourcentage d'incrémentation à chacune des plages de valeurs (430) ;
lire une valeur stockée actuelle dans la banque de mémoire ;
sélectionner le pourcentage d'incrémentation attribué de la plage de valeurs associé à la valeur stockée actuelle comme pourcentage d'incrémentation (540) actuel ; et
incrémenter la valeur stockée actuelle en fonction du pourcentage d'incrémentation (550) actuel ;
le procédé étant **caractérisé en ce que** l'incrémentation de la valeur stockée actuelle en fonction du pourcentage d'incrémentation actuel comprend les étapes consistant à :
vérifier l'état actuel d'au moins quelques bits d'un compteur (610) ; et
déterminer qu'une ou plusieurs valeurs de compteur possibles dans une région non masquée du compteur (610) entraîneront l'incrémentation de la valeur stockée.

2. Procédé selon la revendication 1, la valeur stockée étant une valeur d'intensité stockée.

3. Procédé selon la revendication 1, la vérification de l'état actuel d'au moins quelques bits d'un compteur comprenant l'étape consistant à ajuster plusieurs bits dans une zone masquée du compteur.

4. Incrémenteur stochastique (600) permettant de générer un signal d'incrémentation dans un moniteur de forme d'onde ayant un affichage généré à partir de valeurs de pixel, l'incrémenteur comprenant :
une entrée structurée pour recevoir un signal indiquant qu'une forme d'onde testée correspond à une valeur de pixel actuelle ; et
un générateur stochastique couplé à l'entrée et structuré de sorte à générer le signal d'incrémentation selon une fonction stochastique ;
**caractérisé en ce que** le générateur stochastique comprend :
un compteur (610) ayant plusieurs bits individuels, chaque bit étant individuellement utilisable ; et
un masque programmable structuré pour masquer un ou plusieurs bits du compteur.

5. Incrémenteur stochastique (600) selon la revendication 4, le générateur stochastique comprenant en outre un comparateur structuré pour générer la sortie de signal d'incrémentation en fonction d'un état de l'entrée et d'un état des bits non masqués du compteur.

6. Incrémenteur stochastique (600) selon la revendication 4, le masque programmable (620) étant associé à une plage de valeurs d'incrémentation parmi plusieurs plages de valeurs d'incrémentation.

7. Incrémenteur stochastique (600) selon la revendication 6, les plages de valeurs étant déterminées au moins partiellement en fonction d'une valeur de pixel minimale et d'une valeur de pixel maximale.
